# EUROPEAN PATENT SPECIFICATION

(11) **EP 2 927 952 B1**
(45) Date of publication and mention of the grant of the patent: **18.11.2020**
(21) Application number: 13858816.5
(22) Date of filing: 14.06.2013
(51) Int. Cl.: H01L 23/29, C09J 11/04, C09J 11/06, C09J 201/00, H01L 21/301, H01L 21/52, H01L 23/00, H01L 23/31, H01L 23/373

(54) **SHEET FOR FORMING RESIN FILM FOR CHIPS AND METHOD FOR MANUFACTURING SEMICONDUCTOR DEVICE**
FOLIE ZUR BILDUNG EINES HARZFILMS FÜR CHIPS UND VERFAHREN ZUR HERSTELLUNG EINES HALBLEITERBAUELEMENTS
FEUILLE DE FORMATION DE FILM DE RÉSINE POUR PUCE, ET PROCÉDÉ DE FABRICATION DE DISPOSITIF À SEMI-CONDUCTEURS

(30) Priority: 30.11.2012 JP 2012263046
(43) Date of publication of application: 07.10.2015
(73) Proprietor: Lintec Corporation, Tokyo 173-0001 (JP)
(72) Inventor: AZUMA, Yuichiro, Tokyo 173-0001 (JP); ICHIKAWA, Isao, Tokyo 173-0001 (JP)
(74) Representative: V.O.
(86) International application number: PCT/JP2013/066471
(87) International publication number: WO 2014/083872

(56) References cited:
- WO-A1-2011/125711
- JP-A- 2007 250 970
- JP-A- 2008 248 128
- JP-A- 2011 023 607
- JP-A- 2011 190 302
- JP-A- 2012 028 404
- JP-A- 2012 031 234
- JP-A- 2012 156 474

## Description

### Technical Field

The present invention relates to a sheet for forming a resin film for chips with which a resin film having high bonding strength and high thermal conductivity can be efficiently formed on any surface of a semiconductor chip, and a semiconductor device having high reliability can be manufactured.

In recent years, manufacture of a semiconductor device using a mounting method called a so-called facedown method has been performed. In the facedown method, a semiconductor chip (hereinafter, simply referred to as "chip") having an electrode such as a bump on the circuit surface is used, and the electrode is bonded to the substrate. Therefore, the surface opposite (rear surface of a chip) to the circuit surface of the chip may be exposed.

The exposed rear surface of a chip is protected by an organic film. In the related art, the chip having a protective film formed of the organic film is obtained by applying a liquid resin to a rear surface of a wafer by a spin coating method, drying, curing, and cutting the protective film with the wafer. However, since the thickness precision of the protective film formed in this manner is not sufficient, the yield of products may be low.

In order to solve the above problem, a sheet for forming a protective film for chips having a supporting sheet and a protective film-forming layer formed of a thermosetting component or an energy ray curable component and a binder polymer component, formed on the supporting sheet is disclosed (Patent Citation 1).

In addition, a semiconductor wafer manufactured in a state of a large diameter is cut and separated (diced) into small element pieces (semiconductor chips), and then, is transferred to a bonding step which is the next step. At this time, the semiconductor wafer is subjected to each step of dicing, washing, drying, expanding, and pickup in a state of being stuck to a bonding sheet in advance, and then, is transferred to the bonding step which is the next step.

Among these steps, in order to simplify the processes of the pickup step and the bonding step, various bonding sheets for dicing or die bonding having both a wafer-fixing function and a die-bonding function have been proposed (for example, refer to Patent Citation 2). By using the bonding sheet disclosed in Patent Citation 2, a so-called direct die bonding can be possible, and thus, a coating step of a bonding agent for die bonding can be omitted. For example, by using the bonding sheet, it is possible to obtain a semiconductor chip in which the bonding agent layer is attached to the rear surface, and direct die bonding between an organic substrate and a chip, between a lead frame and a chip, or between a chip and a chip is possible. Such a bonding sheet can have a wafer fixing function and a die bonding function by imparting fluidity to the bonding agent layer, and has a supporting sheet and a bonding agent layer formed of a thermosetting component or an energy ray curable component and a binder polymer component, which is formed on the supporting sheet.

In addition, in the case of using the bonding sheet in a chip of the facedown method in which die bonding is performed in a state in which a bump (electrode) formation surface of a chip is opposed to a chip loading portion, the bonding agent layer is attached to the bump formation surface, that is, the surface of the chip, and die bonding is performed.

With densification of a semiconductor device and increase in speed of a manufacturing step of a semiconductor device in recent years, heat generated from a semiconductor device has become a problem. A semiconductor device is deformed by the heat generated from the semiconductor device, and due to this, trouble or damage is caused, or reduction of the operation speed or malfunction of the semiconductor device occurs, and thus, the reliability of the semiconductor device is reduced, in some cases. Therefore, in a high-performance semiconductor device, efficient heat dissipation characteristics have been required, and it has been considered using a filler having favorable thermal conductivity in a resin film such as a protective film forming layer or a bonding agent layer. For example, in Patent Citation 3, a thermoconductive bonding film obtained by applying a magnetic field to a film composition including a boron nitride powder and by solidifying after orienting the boron nitride powder in the composition in a fixed direction is disclosed. Other thermoconductive resin films having inorganic fillers with improved heat control and dissipation are known from WO2011125711 and JP2011023607.

### Citation List

[Patent Citation 1] Japanese Unexamined Patent Application, First Publication No. 2002-280329
[Patent Citation 2] Japanese Unexamined Patent Application, First Publication No. 2007-314603
[Patent Citation 3] Japanese Unexamined Patent Application, First Publication No. 2002-69392
[Patent Citation 4] Japanese Unexamined Patent Application, First Publication No. 2000-17246

### Disclosure of Invention

### Technical Problem

However, the thermoconductive bonding film formed using the film composition described in Patent Citation 3 has a step of applying a magnetic field in the manufacturing step as described above, and the manufacturing step is complicated. In addition, in the case of forming a resin film using a boron nitride powder having an average particle size of 1 µm to 2 µm disclosed in Example of Patent Citation 3, due to the small particle size, the composition for forming a resin film is thickened. In a case where the composition for forming a resin film is thickened, coating suitability of the composition for forming a resin film is reduced, and a smooth resin film is less likely to be formed. On the other hand, in a case where a small amount of boron nitride powder is added in order to avoid thickening of the composition for forming a resin film, high thermal conductivity of the resin film is not obtained.

In addition, inorganic fillers such as boron nitride have low dispersibility in the composition for forming a resin film used when manufacturing the sheet, and thus, it is difficult to improve the wettability and bondability. As a result, the reliability of the semiconductor device is reduced.

Moreover, in Patent Citation 4, it is described that a compound obtained by adding a silane coupling agent to a polysiloxane oligomer and by condensing is added to the resin composition in order to improve bondability.

The invention has been made in consideration of the above-described circumstances, and an object of the present invention is to provide a sheet which can impart heat dissipation characteristics to the obtained semiconductor device without increasing the number of steps or performing a specific treatment which complicates a process on a semiconductor wafer or a chip in a manufacturing step of the semiconductor device, and has excellent bondability.

### Technical Solution

The present inventors, as a result of intensive studies to solve the above problems, conceived that by adding a specific inorganic filler and a silane coupling agent to a resin film forming layer formed on any surface of a semiconductor chip, it is possible to improve bondability with respect to an object to be bonded (semiconductor wafer, semiconductor chip, or the like) and heat dissipation characteristics of the semiconductor device and completed the present invention.

The present invention is achieved by a sheet for forming a resin film for chips according to claims 1 - 11.

### Advantageous Effects

When forming a resin film on any surface of a semiconductor chip, by using the sheet for forming a resin film for chips according to the present invention, it is possible to form a resin film having excellent peeling strength and thermal conductivity, and it is possible to improve the reliability of the obtained semiconductor device without performing a specific treatment on the semiconductor wafer or chip.

### Best Mode for Carrying out the Invention

Hereinafter, the present invention will be described in more detail also including a best mode thereof. The sheet for forming a resin film for chips according to the present invention has a supporting sheet and a resin film forming layer which is formed on the supporting sheet.

### (Resin Film Forming Layer)

The resin film forming layer includes a binder polymer component (A), a curable component (B), an inorganic filler (C), and a silane coupling agent (D).

### Binder Polymer Component (A)

The binder polymer component (A) is used to impart sufficient bondability (attachability or transfer properties to a semiconductor wafer or the like) and film forming properties (sheet formability) to the resin film forming layer. As the binder polymer component (A), an acrylic polymer, a polyester resin, a urethane resin, an acrylic urethane resin, a phenoxy resin, a silicone resin, a rubber-based polymer, a polystyrene, or the like known in the related art can be used, and the presence or absence of a functional group such as a thermosetting functional group does not matter.

The weight average molecular weight (Mw) of the binder polymer component (A) is preferably 10,000 to 2,000,000, and more preferably 100,000 to 1,500,000. When the weight average molecular weight (Mw) of the binder polymer component (A) is too low, a failure in which the resin film forming layer cannot be transferred by increase of the peeling force between the resin film forming layer and the supporting sheet can be observed. In addition, when the weight average molecular weight (Mw) of the binder polymer component (A) is too high, the bondability of the resin film forming layer is reduced, and due to this, the resin film forming layer cannot be transferred to a chip or the like, or the resin film is peeled from the chip or the like after the transfer in some cases. In addition, when the weight average molecular weight (Mw) of the binder polymer component (A) is too low, sheet formation of the resin film forming layer becomes difficult in some cases.

As the binder polymer component (A), an acrylic polymer is preferably used. The glass transition temperature (Tg) of the acrylic polymer is preferably within a range of -60°C to 50°C, more preferably within a range of -50°C to 40°C, and particularly preferably within a range of -40°C to 30°C. When the glass transition temperature of the acrylic polymer is too low, a failure in which the resin film forming layer cannot be transferred by increase of the peeling force between the resin film forming layer and the supporting sheet occurs in some cases. In addition, when the glass transition temperature of the acrylic polymer is too high, the bondability of the resin film forming layer is reduced, and due to this, the resin film forming layer cannot be transferred to a chip or the like, or the resin film is peeled from the chip or the like after the transfer in some cases. In addition, in a case where the glass transition temperature of the acrylic polymer is too low or in a case where the glass transition temperature of the acrylic polymer is too high, suitable film forming properties cannot be obtained when manufacturing a resin-forming layer, and due to this, sheet formation becomes impossible in some cases.

Examples of the monomer constituting the acrylic polymer include a (meth)acrylic acid ester monomer or a derivative thereof. Examples thereof include an alkyl (meth)acrylate in which the alkyl group has 1 to 18 carbon atoms, a (meth)acrylate having a cyclic skeleton, a (meth)acrylate having a hydroxyl group, and a (meth)acrylate having an epoxy group.

Specific examples of the alkyl (meth)acrylate in which the alkyl group has 1 to 18 carbon atoms include methyl (meth)acrylate, ethyl (meth)acrylate, propyl (meth)acrylate, butyl (meth)acrylate, pentyl (meth)acrylate, hexyl (meth)acrylate, heptyl (meth)acrylate, octyl (meth)acrylate, 2-ethylhexyl (meth)acrylate, nonyl (meth)acrylate, decyl (meth)acrylate, lauryl (meth)acrylate, tetradecyl (meth)acrylate, and octadecyl (meth)acrylate.

Specific examples of the (meth)acrylate having a cyclic skeleton include cycloalkyl (meth)acrylate, benzyl (meth)acrylate, isobornyl (meth)acrylate, dicyclopentanyl (meth)acrylate, dicyclopentenyl (meth)acrylate, dicyclopentenyloxyethyl (meth)acrylate, and imide (meth) acrylate.

Specific examples of the (meth)acrylate having a hydroxyl group include hydroxymethyl (meth)acrylate, 2-hydroxyethyl (meth)acrylate, 2-hydroxypropyl (meth)acrylate, and 4-hydroxybutyl (meth)acrylate.

Specific examples of the (meth)acrylate having an epoxy group include glycidyl (meth)acrylate.

Among these, an acrylic polymer obtained by polymerizing a monomer having a hydroxyl group is preferable since compatibility with the curable component (B) described below is favorable. In addition, in the case of using the acrylic polymer containing a monomer having a hydroxyl group, it is possible to easily crosslink the acrylic polymer by using an organic polyvalent isocyanate compound or the like as a crosslinking agent (H) described below, and it is possible to control the cohesiveness of the resin film forming layer before curing.

In addition, in the above-described acrylic polymer, acrylic acid, methacrylic acid, itaconic acid, vinyl acetate, acrylonitrile, styrene, or the like may be copolymerized.

In addition, in the case of using an epoxy resin as a thermosetting component in the curable component (B) described below, it is preferable to limit the mass ratio of a monomer having an epoxy group in the total mass of the monomers constituting the acrylic polymer to be low. Thus, the bonding strength between the resin film and the chip tends to increase. The reason is considered as follows. In a case where the mass ratio of a monomer having an epoxy group in the total mass of the monomers constituting the acrylic polymer is low, the compatibility of the epoxy resin and the acrylic polymer is reduced, and a phase separation structure having each of the epoxy resin and the acrylic polymer as a main component in the resin film forming layer is formed. As a result, it is considered that this is because the structure having the acrylic polymer as a main component plays a role in buffering a distortion in the resin film, and even after the resin film is gone through the thermal history, local peeling of the bonding interface due to deformation of the resin film is less likely to occur. For the mixing amount of monomer having an epoxy group in the total mass of the monomers constituting the acrylic polymer, it is preferable that the monomer having an epoxy group is not included in the monomers constituting the acrylic polymer, or the mass ratio of a monomer having an epoxy group in the total mass of the monomers constituting the acrylic polymer is greater than 0% by mass and 10% by mass or less, and it is more preferable that the monomer having an epoxy group is not included in the monomers constituting the acrylic polymer, or the mass ratio of a monomer having an epoxy group in the total mass of the monomers constituting the acrylic polymer is greater than 0% by mass and 7% by mass or less.

Examples of the monomer having an epoxy group include a norbornene and the like having an epoxy group, in addition to (meth)acrylates having an epoxy group such as glycidyl (meth)acrylate described above.

Although the acrylic polymer including a monomer having an epoxy group as a monomer constituting the polymer is contextually included in the concept of the epoxy resin described below, in the present invention, the acrylic polymer is not included in the epoxy resin. That is, in the case of mixing an epoxy compound which is a molecule other than the acrylic polymer and has two or more functional groups in the molecule, as a thermosetting component in the curable component (B), in the resin film forming layer, the above-described effects is obtained by using the acrylic polymer.

In addition, the binder polymer component (A) may be used in combination with two or more types of polymers. At this time, polymers having the same degree of the weight average molecular weight may be used, or the polymers may have different weight average molecular weights. By mixing polymers having different weight average molecular weights, the interface peeling between the supporting sheet and the resin film forming layer is likely to occur, or it is possible to suppress generation of voids at the time of transfer.

Furthermore, by selecting the glass transition temperature of the polymer to be mixed with the acrylic polymer, it is also possible to suppress a transfer failure of the resin film forming layer due to the increase in the peeling force with the supporting sheet or the decrease in the bonding force between the resin film forming layer and the chip.

In addition, as the binder polymer component (A), a polymer (energy ray curable type polymer) having an energy ray polymerizable group in the side chain may be used. Such an energy ray curable type polymer has both a function as the binder polymer component (A) and a function as the curable component (B) described below. The energy ray polymerizable group may be the same as an energy ray polymerizable group contained in the energy ray polymerizable compound described below. Examples of the polymer having an energy ray polymerizable group in the side chain include a polymer prepared by reacting a low molecular weight compound having a functional group Y capable of reacting with a reactive functional group X and an energy ray polymerizable group with a polymer having the reactive functional group X in the side chain.

### Curable Component (B)

As the curable component (B), a thermosetting component and a thermosetting agent, or an energy ray polymerizable compound can be used. In addition, these may be used in combination. As the thermosetting component, for example, an epoxy resin is preferable.

As the epoxy resin, epoxy resins known in the related art can be used. Specific examples of the epoxy resin include a multifunctional epoxy resin, and epoxy compounds having two or more functional groups in the molecule such as a biphenyl compound, a bisphenol A diglycidyl ether and their hydrogenated products, an ortho-cresol novolac epoxy resin, a dicyclopentadiene type epoxy resin, a bisphenol type epoxy resin, a bisphenol A type epoxy resin, a bisphenol F type epoxy resin, and a phenylene skeleton type epoxy resin. These can be used alone or in combination of two or more kinds thereof.

In the case of using a thermosetting component and a thermosetting agent as the curable component (B), in the resin film forming layer, the thermosetting component is preferably included in 1 part by mass to 1,500 parts by mass, and more preferably 3 parts by mass to 1,200 parts by mass with respect to 100 parts by mass of the binder polymer component (A). When the content of the thermosetting component is less than 1 part by mass, sufficient bondability is not obtained in some cases, and when the content of the thermosetting component is greater than 1,500 parts by mass, the peeling force between the resin film forming layer and the supporting sheet is increased, and due to this, the transfer failure of the resin film forming layer occurs in some cases.

The thermosetting agent functions as a curing agent with respect to a thermosetting component, in particular, an epoxy resin. Examples of the preferred thermosetting agent include a compound having two or more functional groups capable of reacting with an epoxy group in a molecule. Examples of the functional group include a phenolic hydroxyl group, an alcoholic hydroxyl group, an amino group, a carboxyl group, and an acid anhydride. Among these, the phenolic hydroxyl group, the amino group, or the acid anhydride is preferable, and the phenolic hydroxyl group or the amino group is more preferable.

Specific examples of a phenol-based curing agent having a phenolic hydroxyl group include a multifunctional phenolic resin, biphenol, a novolac type phenolic resin, a dicyclopentadiene-based phenolic resin, a Xylok type phenolic resin, and an aralkyl phenolic resin. Specific examples of an amine-based curing agent having an amino group include DICY (dicyandiamide). These can be used alone or in combination of two or more kinds thereof.

The content of the thermosetting agent is preferably 0.1 parts by mass to 500 parts by mass, and more preferably 1 part by mass to 200 parts by mass with respect to 100 parts by mass of the thermosetting component. When the content of the thermosetting agent is small, bondability is not obtained due to insufficient curing, and when the content of the thermosetting agent is too great, the moisture absorptivity of the resin film forming layer increases, and due to this, the reliability of a semiconductor device is reduced.

The energy ray polymerizable compound includes an energy ray polymerizable group, and when irradiated with an energy ray such as ultraviolet rays or an electron ray, the energy ray polymerizable compound is polymerized and cured. Specific examples of such an energy ray polymerizable compound include acrylate-based compounds such as trimethylolpropane triacrylate, pentaerythritol triacrylate, pentaerythritol tetraacrylate, dipentaerythritol monohydroxy pentaacrylate, dipentaerythritol hexaacrylate, 1,4-butyleneglycol diacrylate, 1,6-hexanediol diacrylate, polyethylene glycol diacrylate, oligoester acrylate, urethane acrylate-based oligomer, epoxy-modified acrylate, polyether acrylate, and itaconic acid oligomer. Such a compound has at least one polymerizable double bond in a molecule, and the weight average molecular weight thereof is usually 100 to 30,000, and preferably about 300 to 10,000. In the case of using the energy ray polymerizable compound as the curable component (B), in the resin film forming layer, the energy ray polymerizable compound is preferably included in 1 part by mass to 1,500 parts by mass, and more preferably 3 parts by mass to 1,200 parts by mass with respect to 100 parts by mass of the binder polymer component (A).

### Inorganic Filler (C)

The inorganic filler (C) contains the nitride particles (C1). By mixing the inorganic filler (C) containing the nitride particles (C1) in the resin film forming layer, the thermal conductivity of the resin film forming layer is improved, and due to this, it is possible to efficiently diffuse the heat emitted from a semiconductor device in which a semiconductor chip to which the resin film forming layer is attached is mounted. In addition, it is possible to adjust the thermal expansion coefficient of the resin film after curing, and it is possible to improve the reliability of the semiconductor device having a semiconductor wafer, a semiconductor chip, a lead frame, an organic substrate, or the like as an object to be bonded. Furthermore, it is possible to decrease the moisture absorptivity of the resin film after curing, and thus, it is possible to maintain the bondability as the resin film at the time of heating and improve the reliability of the semiconductor device. Furthermore, by performing laser marking on the resin film, the inorganic filler (C) is exposed at the portion cut away by a laser light, and a reflected light is diffused, and thus, a color similar to a white color is exhibited. Thus, in a case where the resin film forming layer contains a coloring agent (E) described below, a contrast difference between the laser marking portion and the other portion is obtained, and thus, an effect in which printing becomes clear is exhibited.

In addition, the inorganic filler (C) contains particles (hereinafter, referred to as "other particles (C2)" in some cases) other than the nitride particles (C1). The nitride particles (C1) improve the thermal conductivity of the resin film forming layer; however, when the content ratio of the nitride particles (C1) in the resin film forming layer is too great, the bondability with respect to an object to be bonded to the resin film forming layer is reduced in some cases. Therefore, by using the nitride particles (C1) and the other particles (C2) in combination, it is possible to impart sufficient thermal conductivity to the resin film forming layer, while maintaining the bondability of the resin film forming layer with respect to an object to be bonded.

Hereinafter, the nitride particles (C1) and the other particles (C2) will be described in detail.

### Nitride Particles (C1)

Examples of the nitride particles (C1) include particles of boron nitride, aluminum nitride, and silicon nitride. Among these, the boron nitride particles with which a resin film forming layer having high thermal conductivity is likely to be obtained is preferable.

In addition, the nitride particles (C1) are anisotropic shape particles. The anisotropic shape particles have anisotropy, and the specific shape thereof is preferably at least one shape selected from the group consisting of a plate shape, a needle shape, and a scale shape. The anisotropic shape particles exhibit high thermal conductivity in the long axis direction thereof. Therefore, in a case where the ratio of the anisotropic shape particles in which the long axis direction becomes substantially the same as the thickness direction of the resin film forming layer in the resin film forming layer is increased, the heat generated in the semiconductor chip is likely to be diffused through the resin film forming layer.

Moreover, in the present invention, "the long axis direction of the nitride particles (C1) is substantially the same as the thickness direction of the resin film forming layer", specifically, means that when the angle in a state in which the long axis direction of the nitride particles (C1) is parallel to the thickness direction of the resin film forming layer is defined as 0°, the angle formed between the thickness direction of the resin film forming layer and the long axis direction of the nitride particles (C1) is within a range of -45° to 45°.

The average particle size of the nitride particles (C1) is 20 µm or less, more preferably 5 µm to 20 µm, still more preferably 8 µm to 20 µm, and particularly preferably 10 µm to 15 µm. In addition, the average particle size of the nitride particles (C1) is preferably smaller than the average particle size of the other particles (C2) described below. By adjusting the average particle size of the nitride particles (C1) in the above manner, the thermal conductivity or the film-forming properties of the resin film forming layer is improved, and the filling ratio of the nitride particles (C1) in the resin film forming layer is improved. The average particle size of the nitride particles (C1) is defined as a number average particle size obtained by measuring the long axis sizes of twenty nitride particles (C1) randomly selected using an electron microscope, and by calculating as the arithmetic average value.

The particle size distribution (CV value) of the nitride particles (C1) is preferably 5% to 40%, and more preferably 10% to 30%. When the particle size distribution (CV value) of the nitride particles (C1) is within the above-described range, it is possible to efficiently achieve uniform thermoconductive properties. The CV value is an index of variation in the particle size, and a greater CV value means that variation in the particle size is greater. In a case where the CV value is small, the particles are similar in size, and thus, the amount of small particles having a size capable of entering the gap between the particles becomes small, due to this, it is difficult to more densely fill with the inorganic filler (C), and as a result, the resin film forming layer having high thermal conductivity is less likely to be obtained. In contrast, in a case where the CV value is great, the particle size of the inorganic filler (C) becomes larger than the thickness of the resin film forming layer formed, as a result, irregularities are generated on the surface of the resin film forming layer, and the bondability of the resin film forming layer is reduced, in some cases. In addition, in a case where the CV value is too great, it is difficult to obtain a thermoconductive composition having a uniform performance, in some cases. Moreover, the particle size distribution (CV value) of the nitride particles (C1) can be obtained by measuring the long axis sizes of two hundred particles by observation using an electron microscope, by determining the standard deviation of the long axis sizes, and by calculating (standard deviation of long axis sizes)/(average particle size) using the above-described average particle size.

The aspect ratio of the nitride particles (C1) is preferably 5 or greater, more preferably 5 to 30, still more preferably 8 to 20, and particularly preferably 10 to 15. The aspect ratio is represented by (number average size of long axis)/(number average size of short axis) of the nitride particles (C1). The number average size of the short axis and the number average size of the long axis are defined as a number average particle size obtained by measuring the short axis sizes and the long axis sizes of twenty nitride particles (C1) randomly selected in a transmission electron microscopic photograph, and by calculating as each arithmetic average value. When the aspect ratio of the nitride particles (C1) is within the above-described range, the other particles (C2) prevent the long axis direction of the nitride particles (C1) from becoming substantially the same as the direction parallel to the resin film forming layer, and due to this, the nitride particles (C1) form efficient thermal conduction paths in the thickness direction of the resin film forming layer, and thus, it is possible to improve the thermal conductivity.

The density of the nitride particles (C1) is preferably 2 g/cm³ to 4 g/cm³, and more preferably 2.2 g/cm³ to 3 g/cm³.

The thermal conductivity in the long axis direction of the nitride particles (C1) is preferably 60 W/(m·K) to 400 W/(m·K), and more preferably 100 W/(m·K) to 300 W/(m·K). By using such nitride particles (C1), the formed thermal conduction path has high thermal conductivity, and as a result, a resin film forming layer having high thermal conductivity is obtained. Moreover, the thermal conductivity in the long axis direction of the nitride particles (C1) can be measured by a periodic heating method.

### Other Particles (C2)

The other particles (C2) include silica particles and alumina particles, and the alumina particles are particularly preferable. By using alumina particles, thermoconductive properties are not impaired even at the portion other than the thermal conduction paths formed by the nitride particles, and as a result, a resin film forming layer having high thermal conductivity is obtained.

The shape of the other particles (C2) is not particularly limited as long as the shape prevents the long axis direction of the nitride particles (C1) from becoming substantially the same as the direction parallel to the resin film forming layer, and the specific shape is preferably a spherical shape. By using the other particles (C2) having such a shape, in the manufacturing step of the resin film forming layer, it can inhibit the long axis direction of the nitride particles (C1) to become substantially the same as the direction parallel to the resin film forming layer, and it is possible to increase the ratio of the nitride particles (C1) in which the long axis direction becomes substantially the same as the thickness direction of the resin film forming layer. As a result, a resin film forming layer having excellent thermal conductivity in the thickness direction of the resin film forming layer is obtained. This is because by the presence of the other particles (C2) in the resin film forming layer, the nitride particles (C1) are present so as to be stood against the other particles (C2), and as a result, the long axis direction of the nitride particles (C1) becomes substantially the same as the thickness direction of the resin film forming layer. In the case of using only the anisotropic shape nitride particles (C1), the ratio of the nitride particles (C1) in which the long axis direction becomes substantially the same as the direction parallel to the resin film forming layer is increased by the stress or the gravity applied to the nitride particles (C1) during the manufacturing step (for example, coating step) of the resin film forming layer, and due to this, it is difficult to obtain a resin film forming layer having excellent thermal conductivity, in some cases.

The average particle size of the other particles (C2) is 20 µm or greater, more preferably 20 µm to 50 µm, and still more preferably 20 µm to 30 µm. When the average particle size of the other particles (C2) is within the above-described range, the thermal conductivity or the film-forming properties of the resin film forming layer is improved, and the filling ratio of the other particles (C2) in the resin film forming layer is improved. In addition, the nitride particles (C1) have great specific surface areas per unit volume, and due to this, the viscosity of the composition for forming a resin film is likely to be increased. Here, in a case where the specific surface area is greater, a filler other than nitride particles having an average particle size less than 20 µm is added, the viscosity of the composition for forming a resin film is further increased, and therefore, there is a concern that resin film formation becomes difficult, it needs to be diluted with the large amount of solvent, or the productivity is reduced. Moreover, the average particle size of the other particles (C2) is defined as a number average particle size obtained by measuring the long axis sizes of twenty other particles (C2) randomly selected using an electron microscope, and by calculating as the arithmetic average value.

In addition, the average particle size of the other particles (C2) is preferably 0.01 times to 0.65 times of the thickness of the resin film forming layer described below. When the average particle size of the other particles (C2) is less than 0.01 times of the thickness of the resin film forming layer, the ratio of the nitride particles (C1) in which the long axis direction becomes substantially the same as the direction parallel to the resin film forming layer is increased, due to this, efficient thermal conduction paths are less likely to be formed, and thus, the thermal conductivity of the resin film forming layer is reduced, in some cases. In addition, when the average particle size of the other particles (C2) is greater than 0.65 times of the thickness of the resin film forming layer, irregularities are generated on the surface of the resin film forming layer, and the bondability of the resin film forming layer with respect to an object to be bonded is reduced, in some cases. In addition, it is difficult to obtain a thermoconductive composition for forming a resin film having a uniform performance, in some cases.

The particle size distribution (CV value) of the other particles (C2) is preferably 5% to 40%, and more preferably 10% to 30%. When the particle size distribution (CV value) of the other particles (C2) is within the above-described range, it is possible to efficiently achieve uniform thermoconductive properties. In a case where the CV value is small, the particles are similar in size, and thus, the amount of small particles having a size capable of entering the gap between the particles becomes small, due to this, it is difficult to more densely fill with the inorganic filler (C), and as a result, the resin film forming layer having high thermal conductivity is less likely to be obtained. In contrast, in a case where the CV value is great, the particle size of the inorganic filler (C) becomes larger than the thickness of the resin film forming layer formed, as a result, irregularities are generated on the surface of the resin film forming layer, and the bondability of the resin film forming layer with respect to an object to be bonded becomes poor, in some cases. In addition, in a case where the CV value is too great, it is difficult to obtain a thermoconductive composition having a uniform performance, in some cases. Moreover, the particle size distribution (CV value) of the other particles (C2) can be obtained by measuring the long axis sizes of two hundred particles by observation using an electron microscope, by determining the standard deviation of the long axis sizes, and by calculating (standard deviation of long axis sizes)/(average particle size) using the above-described average particle size.

The mass ratio of the inorganic filler (C) in the total mass of the resin film forming layer is preferably 30% by mass to 60% by mass, more preferably 40% by mass to 60% by mass, and particularly preferably 50% by mass to 60% by mass with respect to the total solid content constituting the resin film forming layer. When the mass ratio of the inorganic filler (C) is within the above-described range, efficient thermal conduction paths can be formed, and it is possible to improve the thermal conductivity of the resin film forming layer.

In addition, the mass ratio of the nitride particles (C1) in the total mass of the resin film forming layer is preferably 40% by mass or less, more preferably 20% by mass to 40% by mass, and particularly preferably 20% by mass to 30% by mass. When the mass ratio of the nitride particles (C1) is within the above-described range, efficient thermal conduction paths can be formed, and it is possible to improve the thermal conductivity of the resin film forming layer.

In the case of including the nitride particles (C1) and the other particles (C2) as the inorganic filler (C), the weight ratio (C1:C2) of the nitride particles (C1) and the other particles (C2) is preferably 1:5 to 5:1, and more preferably 1:4 to 4:1. When the weight ratio of the nitride particles (C1) and the other particles (C2) is within the above-described range, it is possible to increase the ratio of the nitride particles (C1) in which the long axis direction becomes substantially the same as the thickness direction of the resin film forming layer. As a result, it is possible to improve the thermal conductivity of the resin film forming layer. In addition, it is possible to suppress the increase in viscosity of the composition for forming a resin film, and it is possible to form a smooth resin film.

In addition, the concentration of the inorganic filler (C) in the resin film forming layer is preferably 30% by volume to 50% by volume, and more preferably 35% by volume to 45% by volume.

### Silane Coupling Agent (D)

By mixing the silane coupling agent (D) which has a functional group which reacts with an inorganic material and a functional group which reacts with an organic functional group, and which has a molecular weight of 300 or greater in the resin film forming layer, it is possible to improve the bondability of the resin film forming layer with respect to an object to be bonded. In addition, by using the silane coupling agent (D), it is possible to improve the water resistance without impairing the heat resistance of the resin film obtained by curing the resin film forming layer. Moreover, hereinafter, the "functional group which reacts with an inorganic material" is described as "reactive functional group A", and the "functional group which reacts with an organic functional group" is described as "reactive functional group B", in some cases.

Examples of the silane coupling agent (D) used in the present invention include an oligomer type silane coupling agent having a molecular weight of 300 or greater. The molecular weight of the silane coupling agent (D) is preferably 300 to 5,000, and more preferably 1,000 to 3,000. Furthermore, the alkoxy equivalent of the silane coupling agent (D) is preferably 10 mmol/g to 40 mmol/g, and more preferably 13 mmol/g to 30 mmol/g.

As the reactive functional group A, an alkoxy group is preferable. In addition, as the reactive functional group B, a reactive functional group which reacts with the functional group that the binder polymer component (A) or the curable component (B) has is preferable, and examples thereof include an epoxy group, an amino group, a (meth)acryloyl group, a vinyl group other than the vinyl groups in a (meth)acryloyl group, and a mercapto group, and among these, the epoxy group is preferable. Moreover, the alkoxy equivalent indicates the absolute number of the alkoxy group included in a compound per unit weight.

By using such a silane coupling agent (D), it is easy to obtain a resin film forming layer having a predetermined peeling strength, while maintaining the thermal conductivity of the resin film forming layer.

Specific examples of such a silane coupling agent (D) include a oligomer type silane coupling agent which is a product obtained by condensing a low molecular weight silane coupling agent having two or three alkoxy groups such as γ-glycidoxypropyl trimethoxysilane, γ-glycidoxypropyl triethoxysilane, γ-glycidoxypropylmethyl diethoxysilane, or γ-(methacrylonitrilepropyl)trimethoxysilane; or a low molecular weight silane coupling agent having four alkoxy groups such as tetramethoxysilane or tetraethoxysilane by hydrolysis or dehydration condensation of the alkoxy groups. In particular, an oligomer which is a product obtained by condensing a low molecular weight silane coupling agent having two or three alkoxy groups and a low molecular weight silane coupling agent having four alkoxy groups among the above-described low molecular weight silane coupling agents by dehydration condensation is preferable since the oligomer has highly reactive alkoxy groups and a functional group which reacts with a sufficient number of organic functional groups. Examples of such an oligomer include an oligomer which is a copolymer of 3-(2,3-epoxypropoxy)propyl methoxysiloxane and dimethoxysiloxane.

The mass ratio of the silane coupling agent (D) in the total mass of the resin film forming layer is preferably 0.3% by mass to 2% by mass, more preferably 0.5% by mass to 2% by mass, and particularly preferably 1% by mass to 2% by mass. When the mass ratio of the silane coupling agent (D) is within the above-described range, the reactive functional group A of the silane coupling agent (D) is efficiently chemically reacted with the inorganic filler (C) (in particular, the other particles (C2)), and the reactive functional group B is efficiently chemically reacted with a functional group that the binder polymer component (A), the curable component (B), or the like has, as a result, a network is formed, and therefore, it is possible to suppress the reduction of the bondability of the resin film forming layer by the nitride particles (C1).

In addition, the resin film forming layer in the present invention may contain a silane compound (D') (hereinafter, simply referred to as "silane compound (D')") which does not have the reactive functional group B, and has a molecular weight of 300 or greater and an alkoxy equivalent of 10 mmol/g or greater. Since the silane compound (D') does not have the reactive functional group B, the silane compound (D') does not react with a functional group that the binder polymer component (A), the curable component (B), or the like has; however, since the silane compound (D') has the reactive functional group A, the silane compound (D') is involved in curing of the resin film forming layer by reacting with an alkoxy group of another molecule, the surface of an object to be bonded, or the surface of the inorganic filler (C) (in particular, the other particles (C2)). Examples of the silane compound (D') include polymethoxy siloxane, polyethoxy siloxane, and a copolymer of methoxy siloxane and dimethyl siloxane.

### Other Components

The resin film forming layer can include the following components in addition to the binder polymer component (A), the curable component (B), the inorganic filler (C), and the silane coupling agent (D).

### Coloring Agent (E)

A coloring agent (E) can be mixed in the resin film forming layer. By mixing the coloring agent in the resin film forming layer, when incorporating a semiconductor device into an apparatus, it is possible to prevent malfunction of the semiconductor device due to infrared rays or the like generated from ambient devices. This effect is useful, in particular, in the case of using a resin film as a protective film. As the coloring agent, organic or inorganic pigments or dyes are used.

As the dye, any dye of an acid dye, a reactive dye, a direct dye, a disperse dye, and a cationic dye can be used. In addition, the pigment is not particularly limited, and a pigment can be suitably selected from known pigments and used.

Among these, a black pigment is preferable in terms of electromagnetic wave- or ultraviolet-shielding properties. As the black pigment, carbon black, iron oxide, manganese dioxide, aniline black, activated carbon, or the like can be used; however, the black pigment is not limited thereto. From the viewpoint of improving the reliability of a semiconductor device, carbon black is particularly preferable. The coloring agent (E) may be used alone or two or more types may be used in combination.

The mixing amount of coloring agent (E) is preferably 0.1 parts by mass to 35 parts by mass, more preferably 0.5 parts by mass to 25 parts by mass, and particularly preferably 1 part by mass to 15 parts by mass with respect to 100 parts by mass of the total solid content constituting the resin film forming layer excluding the coloring agent (E).

### Curing Accelerator (F)

The curing accelerator (F) is used to adjust the cure rate of the resin film forming layer. In particular, in the case of using at least a thermosetting component and a thermosetting agent as the curable component (B), the curing accelerator (F) is preferably used when using an epoxy resin and a thermosetting agent in combination.

Examples of the preferred curing accelerator include tertiary amines such as triethylenediamine, benzyldimethylamine, triethanolamine, dimethylaminoethanol, and tris(dimethylaminomethyl)phenol; imidazoles such as 2-methylimidazole, 2-phenylimidazole, 2-phenyl-4-methylimidazole, 2-phenyl-4,5-dihydroxymethylimidazole, and 2-phenyl-4-methyl-5-hydroxymethylimidazole; organic phosphines such as tributylphosphine, diphenylphosphine, and triphenylphosphine; and tetraphenyl borates such as tetraphenylphosphonium tetraphenyl borate and triphenylphosphine tetraphenyl borate. These can be used alone or in combination of two or more kinds thereof.

The curing accelerator (F) is preferably included in 0.01 part by mass to 10 parts by mass, and more preferably 0.1 parts by mass to 5 parts by mass with respect to 100 parts by mass of the total amount of the thermosetting component and the thermosetting agent. When the curing accelerator (F) is contained within the above-described range, excellent bondability is exhibited even in the case of being exposed to a high temperature and high humidity, and it is possible to achieve high reliability even in the case of being exposed to severe reflow conditions. When the content of the curing accelerator (F) is small, sufficient bondability is not obtained due to insufficient curing, and when the content of the curing accelerator (F) is too great, a curing accelerator having high polarity moves to the bonding interface side in the resin film forming layer at high temperature and high humidity, and due to the segregation, the reliability of a semiconductor device is reduced.

### Photopolymerization Initiator (G)

In a case where the resin film forming layer contains an energy ray polymerizable compound as the curable component (B), when using it, the energy ray polymerizable compound is cured by irradiation with energy rays such as ultraviolet rays. At this time, by including the photopolymerization initiator (G) in the composition constituting the resin film forming layer, it is possible to reduce the polymerization curing time and the beam irradiation amount.

Specific examples of such a photopolymerization initiator (G) include benzophenone, acetophenone, benzoin, benzoin methyl ether, benzoin ethyl ether, benzoin isopropyl ether, benzoin isobutyl ether, benzoin benzoic acid, methyl benzoin benzoate, benzoin dimethyl ketal, 2,4-diethyl thioxanthone, α-hydroxycyclohexyl phenyl ketone, benzyl diphenyl sulfide, tetramethyl thiuram monosulfide, azobisisobutyronitrile, benzyl, dibenzyl, diacetyl, 1,2-diphenylmethane, 2-hydroxy-2-methyl-1-[4-(1-methylvinyl)phenyl]propanone, 2,4,6-trimethylbenzoyldiphenyl phosphine oxide, and β-chloroanthraquinone. The photopolymerization initiator (G) can be used alone or in combination of two or more kinds thereof.

The photopolymerization initiator (G) is preferably included in 0.1 parts by mass to 10 parts by mass, and more preferably 1 part by mass to 5 parts by mass with respect to 100 parts by mass of the energy ray polymerizable compound. When the photopolymerization initiator (G) is less than 0.1 parts by mass, satisfactory transfer properties are not obtained due to insufficient photopolymerization in some cases, and when the photopolymerization initiator (G) is greater than 10 parts by mass, a residue that does not contribute to the photopolymerization is generated, and the curability of the resin film forming layer becomes insufficient in some cases.

### Crosslinking Agent (H)

In order to adjust the initial bonding force and cohesive force of the resin film forming layer, a crosslinking agent can also be added. Examples of the crosslinking agent (H) include an organic polyvalent isocyanate compound and an organic polyvalent imine compound.

Examples of the organic polyvalent isocyanate compound can include an aromatic polyvalent isocyanate compound, an aliphatic polyvalent isocyanate compound, an alicyclic polyvalent isocyanate compound, trimers of these organic polyvalent isocyanate compounds, and an isocyanate-terminated urethane prepolymer obtained by reacting these organic polyvalent isocyanate compounds and a polyol compound.

Specific examples of the organic polyvalent isocyanate compound include 2,4-tolylene diisocyanate, 2,6-tolylene diisocyanate, 1,3-xylylene diisocyanate, 1,4-xylylene diisocyanate, diphenylmethane-4,4'-diisocyanate, diphenylmethane-2,4'-diisocyanate, 3-methyldiphenylmethane diisocyanate, hexamethylene diisocyanate, isophorone diisocyanate, dicyclohexyl methane-4,4'-diisocyanate, dicyclohexyl methane-2,4'-diisocyanate, trimethylolpropane adduct tolylene diisocyanate, and lysine isocyanate.

Specific examples of the organic polyvalent imine compound include N,N'-diphenylmethane-4,4'-bis(1-aziridinecarboxamide), trimethylolpropane-tri-β-aziridinylpropionate, tetramethylolmethane-tri-β-aziridinylpropionate, and N,N'-toluene-2,4-bis(1-aziridinecarboxamido)triethylene melamine.

The crosslinking agent (H) is used in a proportion of usually 0.01 parts by mass to 20 parts by mass, preferably 0.1 parts by mass to 10 parts by mass, and more preferably 0.5 parts by mass to 5 parts by mass with respect to 100 parts by mass of the binder polymer component (A).

### General-Purpose Additive (I)

Various additives other than the above materials may be mixed in the resin film forming layer as necessary. Examples of the various additives include a leveling agent, a plasticizer, an antistatic agent, an antioxidant, an ion scavenger, a gettering agent, and a chain transfer agent.

The resin film forming layer formed of the respective components described above has bondability and curability, and, in the uncured state, the resin film forming layer is bonded to a semiconductor chip or the like by being pressed, or by being pressed with heating. Through curing, finally, a resin film having high impact resistance can be obtained, and since the peeling strength thereof is excellent, a sufficient protection function can be maintained under severe high temperature and high humidity conditions. In the present invention, the above-described resin film forming layer is preferably used as a film form bonding agent for fixing a semiconductor chip to a substrate or another semiconductor chip or a protective film of the semiconductor chip. Moreover, the resin film forming layer may have a single layer structure, or a multilayer structure as long as the resin film forming layer includes one or more layers including the above-described components.

The peeling strength of the resin film forming layer is preferably 3.5 N/10 mm to 10 N/10 mm, more preferably 5 N/10 mm to 10 N/10 mm, and particularly preferably 7 N/10 mm to 10 N/10 mm. When the peeling strength of the resin film forming layer is within the above-described range, it is possible to manufacture a semiconductor device having excellent reliability. Moreover, the peeling strength of the resin film forming layer is measured by the same method as that in the Example.

The thermal conductivity of the resin film forming layer is preferably 2 W/(m·K) or higher, and more preferably 3 W/(m·K) or higher. In addition, the thermal conductivity of the resin film forming layer (resin film) after curing is preferably 2 W/(m·K) or higher, and more preferably 3 W/(m·K) or higher. When the thermal conductivity of the resin film forming layer or the resin film is less than 2 W/(m·K), a semiconductor device is deformed by the heat generated by the semiconductor device, and due to this, trouble or damage is caused, or reduction of the operation speed or malfunction of the semiconductor device occurs, and thus, the reliability of the semiconductor device is reduced, in some cases. When the thermal conductivity of the resin film forming layer or the resin film is within the above-described range, it is possible to improve the heat dissipation characteristics of the semiconductor device, and it is possible to manufacture a semiconductor device having excellent reliability. Moreover, the thermal conductivity of the resin film forming layer is measured by the same method as that in Example.

As an indicator of the heat dissipation characteristics of the resin film forming layer, in addition to the thermal conductivity, a thermal diffusivity can be used, and the thermal diffusivity of the resin film forming layer (resin film) after curing is preferably 9.7 x 10⁻⁷ m²/s or greater, and more preferably 1.5 × 10⁻⁶ m²/s or greater. In addition, the thermal diffusivity is a value obtained by dividing the thermal conductivity of the resin film forming layer or the resin film by the product of the specific heat and the density of the resin film, and as the thermal diffusivity is increased, superior heat dissipation characteristics are exhibited.

### (Sheet for Forming Resin Film for Chips)

The resin film forming layer is obtained by applying a composition for forming a resin film formed by mixing the respective components described above in a suitable ratio onto a supporting sheet and drying. In addition, a film is formed by applying the composition for forming a resin film onto a step film different from the supporting sheet and drying, and this may be transferred onto the supporting sheet. When mixing, the respective components may be diluted with a dispersion medium or a solvent in advance, or when mixing, a dispersion medium or a solvent may be added. A solvent is preferably used from the viewpoint of being capable of uniformly mixing the respective components. Examples of the solvent include toluene, xylene, methanol, ethanol, isobutanol, n-butanol, ethyl acetate, methyl ethyl ketone, acetone, tetrahydrofuran, isopropanol, dimethylformamide, and N-methylpyrrolidone. These may be used alone or two or more kinds may be used in combination.

The sheet for forming a resin film for chips according to the present invention is obtained by peelably forming the resin film forming layer on a supporting sheet. The shape of the sheet for forming a resin film for chips according to the present invention may be any form of a tape form, a label form, and the like.

Examples of the supporting sheet include films such as a polyethylene film, a polypropylene film, a polybutene film, a polybutadiene film, a polymethylpentene film, a polyvinyl chloride film, a vinyl chloride copolymer film, a polyethylene terephthalate film, a polyethylene naphthalate film, a polybutylene terephthalate film, a polyurethane film, an ethylene vinyl acetate copolymer film, an ionomer resin film, an ethylene-(meth)acrylic acid copolymer film, an ethylene-(meth)acrylic acid ester copolymer film, a polystyrene film, a polycarbonate film, a polyimide film, and a fluorine resin film. In addition, crosslinked films of these are also used. Furthermore, laminated films of these films may be used. In addition, it is also possible to use films obtained by coloring these films.

When using the sheet for forming a resin film for chips of the present invention, the supporting sheet is peeled, and the resin film forming layer is transferred to a semiconductor wafer or a chip. In particular, in the case of peeling the supporting sheet after thermal curing of the resin film forming layer, the supporting sheet is required to endure the heat during the thermal curing of the resin film forming layer, and therefore, an annealing-treated polyethylene terephthalate film, polyethylene naphthalate film, polymethyl pentene film, or polyimide film which has excellent heat resistance is preferably used. In addition, it is also possible to perform a peeling treatment by applying a peeling agent to the surface of the supporting sheet.

As the peeling agent used in the peeling treatment, an alkyd-based peeling agent, a silicone-based peeling agent, a fluorine-based peeling agent, an unsaturated polyester-based peeling agent, a polyolefin-based peeling agent, a wax-based peeling agent, or the like can be used, and in particular, the alkyd-based peeling agent, the silicone-based peeling agent, and the fluorine-based peeling agent are preferable since these peeling agents have heat resistance.

In order to perform the peeling treatment on the surface of a film or the like which becomes the base of the supporting sheet using the above-described peeling agent, the peeling agent which is solvent-free, diluted with a solvent, or emulsified is applied using a gravure coater, a meyer bar coater, an air knife coater, or a roll coater, and then, by placing the supporting sheet coated with the peeling agent under room temperature or under heating, or by curing with an electron beam, a peeling agent layer may be formed.

In addition, the supporting sheet may be obtained by performing lamination of films by wet lamination, dry lamination, hot melt lamination, melt extrusion lamination, or by co-extrusion.

In addition, the resin film forming layer may be laminated on a repeelable adhesive agent layer provided on the supporting sheet. As the repeelable adhesive agent layer, a weak adhesive repeelable adhesive agent layer having an adhesive force capable of peeling the resin film forming layer may be used, and an energy ray curable repeelable adhesive agent layer in which the adhesive force is reduced by irradiation with energy rays may be used. In addition, in the case of using the energy ray curable repeelable adhesive agent layer, the adhesive force is reduced by irradiating a region (for example, an inner peripheral portion of the supporting sheet) where the resin film forming layer is laminated with energy rays, in advance, and by not irradiating the other regions (for example, an outer peripheral portion of the supporting sheet) with energy rays, a high adhesive force may be maintained, for example, for the purpose of adhesion to a jig. In order to perform irradiation such that only the other regions are not irradiated with energy rays, for example, an energy ray shielding layer is provided in the region corresponding to the other regions of the supporting sheet by printing or the like, and irradiation with energy rays may be performed from the supporting sheet side. The repeelable adhesive agent layer can be formed by various known adhesive agents in the related art (examples thereof include general-purpose adhesive agents such as rubber-based, acryl-based, silicone-based, urethane-based, and vinyl ether-based adhesive agent, an energy ray curing type adhesive agents, and a thermal expansion component-containing adhesive agent, and in addition, adhesive agent having unevenness on the surface of the adhesive agent may be used). The thickness of the repeelable adhesive agent layer is not particularly limited, but the thickness is usually 1 µm to 50 µm, and preferably 5 µm to 30 µm. The supporting sheet in the sheet for forming a resin film for chips having such a constitution, in particular, in the case of using a resin film as a protective film, functions as a dicing sheet for supporting the object to be bonded (semiconductor wafer or chip) in the dicing step which is a step of manufacturing a semiconductor device described below, and the bondability between the supporting sheet and the resin film forming layer can be maintained, and thus, it is possible to inhibit the chip to which the resin film forming layer is attached to be peeled from the supporting sheet in the dicing step.

The thickness of the supporting sheet is usually 10 µm to 500 µm, preferably 15 µm to 300 µm, and particularly preferably 20 µm to 250 µm.

The thickness of the resin film forming layer is preferably 25 µm to 50 µm, and particularly preferably 30 µm to 45 µm. In addition, the thickness of the resin film forming layer is preferably greater than the average particle size of the other particles (C2).

Moreover, before using the sheet for forming a resin film for chips, in addition to the supporting sheet, a lightly peelable peeling film may be laminated on the upper surface of the resin film forming layer in order to protect the resin film forming layer.

In addition, another bonding agent layer or adhesive tape may be provided in order to fix other jigs such as a ring frame on the outer peripheral portion of the surface (surface in contact with the object to be bonded) of the resin film forming layer.

The resin film forming layer of the sheet for forming a resin film for chips can function as a film form bonding agent. The film form bonding agent is attached to any side of a semiconductor wafer usually, and after being cut into respective chips through a dicing step, the chips are mounted on a substrate (die bonding), and through a curing step, the semiconductor chips are bonded and fixed. Such a film form bonding agent is referred to as a die attachment film sometimes. A semiconductor device using the resin film forming layer in the present invention as the film form bonding agent has excellent heat dissipation characteristics, and thus, it is possible to suppress the reduction in reliability thereof.

In addition, the resin film forming layer of the sheet for forming a resin film for chips can be used as a protective film. The resin film forming layer is attached to the rear surface of the semiconductor wafer for chips or a semiconductor chip of a face-down method, and then, is cured by suitable means, and due to this, the resin film forming layer has a function of protecting the semiconductor chips as an alternative means of a sealing resin. In the case of being attached to the semiconductor wafer, the protective film has a function of reinforcing the wafer, and thus damage of the wafer can be prevented. In addition, a semiconductor device having the resin film forming layer in the present invention as a protective film has excellent heat dissipation characteristics, and thus, it is possible to suppress the reduction in reliability thereof.

### (Method of Manufacturing Semiconductor Device)

Next, the method for using the sheet for forming a resin film for chips according to the present invention will be described using a case in which the sheet is applied to the method for manufacturing a semiconductor device as an example.

In the method for manufacturing a semiconductor device according to the present invention, it is preferable to obtain a semiconductor chip having a resin film on the rear surface after the resin film forming layer of the sheet for forming a resin film for chips is attached to the rear surface of a semiconductor wafer in which a circuit is formed on the surface. The resin film is preferably a protective film of a semiconductor chip. In addition, the method for manufacturing a semiconductor device according to the present invention preferably further includes the following Steps (1) to (3), and Steps (1) to (3) may be performed in an arbitrary order.
Step (1): A supporting sheet is peeled from a resin film forming layer or a resin film,
Step (2): A resin film is obtained by curing the resin film forming layer, and
Step (3): A semiconductor wafer and the resin film forming layer or the resin film are diced.

The semiconductor wafer may be a silicon wafer, or may be a compound semiconductor wafer of gallium-arsenic or the like. Formation of a circuit on the wafer surface can be performed by various methods including methods which are widely used in the related art such as an etching method and a lift-off method. Next, the opposite surface (rear surface) of the circuit surface of the semiconductor wafer (back) is ground. The grinding method is not particularly limited, but grinding may be performed by known means using a grinder or the like. At the time of grinding the rear surface, an adhesive sheet which is called a surface protective sheet is attached to the circuit surface in order to protect the circuit of the surface. The rear surface grinding is performed by grinding the rear surface on which a circuit is not formed, using a grinder after fixing the circuit surface side (that is, surface protective sheet side) of a wafer using a chuck table or the like. The thickness after grinding of the wafer is not particularly limited, but the thickness is usually about 20 µm to 500 µm.

Thereafter the fractured layer generated at the time of grinding the rear surface is removed as necessary. Removal of the fractured layer is performed by chemical etching or plasma etching.

Next, the resin film forming layer of the sheet for forming a resin film for chips is attached to the rear surface of the semiconductor wafer. Thereafter, Steps (1) to (3) are performed in an arbitrary order. The details of this process are described in Patent Citation 1. As an example, the case of performing Steps (1), (2), and (3) in this order will be described.

First, the resin film forming layer of the sheet for forming a resin film for chips is attached to the rear surface of a semiconductor wafer in which a circuit is formed on the surface. Next, the supporting sheet is peeled from the resin film forming layer, whereby a laminate of the semiconductor wafer and the resin film forming layer is obtained. Next, the resin film forming layer is cured, whereby a resin film is formed on the entire surface of the wafer. In the case of using a thermosetting component and a thermosetting agent as the curable component (B) in the resin film forming layer, the resin film forming layer is cured by thermal curing. In a case where an energy ray polymerizable compound is mixed as the curable component (B), curing of the resin film forming layer can be performed by irradiation with energy rays, and in a case where a thermosetting component, a thermosetting agent, and an energy ray polymerizable compound are used in combination, curing by heating and curing by irradiation with energy rays may be performed at the same time, or may be sequentially performed. Examples of the energy rays to be applied include ultraviolet rays (UV) and an electron beam (EB), and ultraviolet rays are preferably used. As a result, a resin film formed of a curable resin is formed on the rear surface of the wafer, and due to this, the strength is improved compared to the case of a wafer alone, and thus, it is possible to reduce damage at the time of handling the thinned wafer. In addition, by formation of a resin film having high thermal conductivity, excellent heat dissipation properties are imparted. In addition, the above-described method is excellent in the uniformity of the thickness of the resin film compared to the coating method in which a coating liquid for a resin film is directly applied to the rear surface of a wafer or a chip, and due to this, a film is formed.

Next, the laminate of the semiconductor wafer and the resin film is diced for each circuit formed on the wafer surface. The dicing is performed such that the wafer and the resin film are cut together. The wafer dicing is performed by a common method using a dicing sheet. As a result, a semiconductor chip having a resin film on the rear surface is obtained.

Finally, the diced chip is picked up by universal means such as a collet, whereby a semiconductor chip having a resin film is obtained on the rear surface. Furthermore, it is possible to manufacture a semiconductor device by mounting the semiconductor chip on a predetermined base by a facedown method. In addition, it is also possible to manufacture a semiconductor device by bonding a semiconductor chip having a resin film on the rear surface on a die pad portion or other members (chip loading portion) such as other semiconductor chips. According to the present invention, a resin film having high uniformity of a thickness can be easily formed on the rear surface of a chip, and cracks after the dicing step or a packaging step is less likely to occur. Furthermore, since excellent heat dissipation characteristics are imparted to the obtained semiconductor device, it is possible to suppress the reduction in reliability thereof.

Moreover, in the case of performing Step (3) before Step (1) after attaching the resin film forming layer of the sheet for forming a resin film for chips on the rear surface of a semiconductor wafer, the sheet for forming a resin film for chips can play a role as a dicing sheet. That is, the sheet for forming a resin film for chips can be used as a sheet for supporting a semiconductor wafer during the dicing step. In this case, the semiconductor wafer is adhered to the inner peripheral portion of the sheet for forming a resin film for chips through the resin film forming layer, the outer peripheral portion of the sheet for forming a resin film for chips is joined with other jigs such as a ring frame, and as a result, the sheet for forming a resin film for chips attached to the semiconductor wafer is fixed to the device, and dicing is performed.

In addition, a method for manufacturing other semiconductor devices using the sheet for forming a resin film for chips according to the present invention preferably includes a step in which the resin film forming layer of the sheet is adhered to a semiconductor wafer, a semiconductor chip is obtained by dicing the semiconductor wafer, the resin film forming layer is fixed and remains on any surface of the semiconductor chip, is peeled from the supporting sheet, and the semiconductor chip is mounted on the die pad or another semiconductor chip through the resin film forming layer. As an example, a method for attaching the resin film forming layer on the rear surface of a chip will be described below.

First, the rear surface side of a ring frame and a semiconductor wafer are mounted on the resin film forming layer of the sheet for forming a resin film for chips according to the present invention followed by lightly pressing, whereby the semiconductor wafer is fixed. Moreover, in a case where the sheet for forming a resin film for chips according to the present invention has a constitution in which the resin film forming layer is formed on the inner peripheral portion of the supporting sheet through the repeelable adhesive agent layer, and the repeelable adhesive agent layer is exposed to the outer peripheral portion of the supporting sheet, the semiconductor wafer is fixed to the resin film forming layer, and the ring frame is fixed through the repeelable adhesive agent layer at the outer peripheral portion of the supporting sheet.

At this time, in a case where the resin film forming layer is not sticky at room temperature, heating may be suitably performed (the temperature is not limited, but 40°C to 80°C is preferable).

Next, in a case where an energy ray polymerizable compound is mixed in the resin film forming layer as the curable component (B), by irradiating the resin film forming layer with energy rays from the supporting sheet side, the resin film forming layer is preliminarily cured, the cohesive force of the resin film forming layer is increased, and thus, the bonding force between the resin film forming layer and the supporting sheet may be reduced.

Thereafter, the above-described semiconductor wafer is cut by using cutting means such as a dicing saw, whereby a semiconductor chip is obtained. The cutting depth at this time is defined as a depth considering the sum of the thickness of the semiconductor wafer and the thickness of the resin film forming layer, and the worn amount of the dicing saw.

Moreover, irradiation with energy rays may be performed at any stage after attachment of the semiconductor wafer or before peeling (pickup) of the semiconductor chip, and for example, the irradiation may be performed after dicing, or may be performed after an expanding step described below, but the irradiation is preferably performed before dicing after attachment of the semiconductor wafer. Furthermore, irradiation with energy rays may be separately performed multiple times.

Next, when expanding of the sheet for forming a resin film for chips is performed as necessary, an interval between semiconductor chips is extended, and thus, pickup of semiconductor chips is more easily performed. At this time, by occurrence of deviation between the resin film forming layer and the supporting sheet, the bonding force between the resin film forming layer and the supporting sheet is reduced, and thus, pickup properties of the semiconductor chip are improved. When performing pickup of the semiconductor chips in this manner, the cut resin film forming layer is fixed and remains on the rear surface of the semiconductor chip, and can be peeled from the supporting sheet.

Next, the semiconductor chip is mounted on the die pad of a lead frame or the surface of another semiconductor chip (lower chip) through the resin film forming layer (hereinafter, the die pad or the lower chip surface on which a chip is mounted is referred to as "chip loading portion"). The chip loading portion may be heated before the semiconductor chip is mounted or may be heated immediately after the semiconductor chip is mounted. The heating temperature is usually 80°C to 200°C, and preferably 100°C to 180°C, the heating time is usually 0.1 seconds to 5 minutes, and preferably 0.5 seconds to 3 minutes, and the pressure at the time of mounting is usually 1 kPa to 200 MPa.

After the semiconductor chip was mounted on the chip loading portion, heating may be further performed as necessary. As the heating conditions at this time, the heating temperature is within the above-described range, and the heating time is usually 1 minute to 180 minutes, and preferably 10 minutes to 120 minutes.

In addition, in a temporary bonding state without performing a heating treatment after mounting, the resin film forming layer may be cured by using heating in a resin sealing that is usually performed in the package manufacture. The resin film forming layer is cured through such steps, and as a result, it is possible to obtain a semiconductor device in which a semiconductor chip and a chip loading portion are firmly bonded. Since the resin film forming layer is fluidized in the die bonding conditions, the resin film forming layer is sufficiently embedded in irregularities of the chip loading portion, and due to this, occurrence of voids can be prevented, and the reliability of the semiconductor device increases. In addition, since the thermal conductivity of the resin film forming layer is high, the semiconductor device has excellent heat dissipation characteristics, and thus, it is possible to suppress the reduction in reliability thereof.

The sheet for forming a resin film for chips of the present invention can also be used for bonding a semiconductor compound, glass, ceramics, metal, or the like, in addition to methods for use as described above.

### Examples

Hereinafter, the present invention will be described based on Examples, but the present invention is not limited to the Examples. Moreover, in the following Examples and Comparative Examples, <Evaluation of Peeling Strength> and <Measurement of Thermal Conductivity> were performed as follows.

### <Evaluation of Peeling Strength>

A silicon wafer having a thickness of 350 µm was mounted on a resin film forming layer of a sheet for forming a resin film for chips, followed by thermally laminating at 70°C. Next, the supporting sheet of the sheet for forming a resin film for chips was peeled. Thereafter, a copper foil (thickness 150 µm) having a width of 10 mm was thermally laminated on the resin film forming layer at 70°C, and after thermal curing (130°C, 2 hours) was performed thereon in a heating oven, a 90° peel test was performed using a universal tensile testing machine (AG-IS MS manufactured by Shimadzu Co.), and the peeling strength the copper foil was measured. A case where the peeling strength was 3.5 N/10 mm to 10 N/10 mm was evaluated as "favorable", and other cases were evaluated as "poor".

### <Measurement of Thermal Conductivity>

### (Before Curing)

A resin film forming layer (thickness: 40 µm) was cut into square pieces having a side length of 1 cm, and these were used as test samples. Next, using a thermal conductivity measuring device (ai-Phase-Mobile 1u manufactured by ai-Phase Co., Ltd.), the thermal conductivities in the thickness direction of the test samples were measured by a temperature thermal analysis method. A case where the thermal conductivity was 2 W/(m·K) or higher was evaluated as "favorable", and other cases were evaluated as "poor".

### (After Curing)

A resin film forming layer (thickness: 40 µm) was cut into square pieces having a side length of 1 cm, and these were used as test samples. Next, after curing the test samples by heating (130°C, 2 hours), using the thermal conductivity measuring device (ai-Phase-Mobile 1u manufactured by ai-Phase Co., Ltd.), the thermal conductivities of the test samples were measured. A case where the thermal conductivity was 2 W/(m·K) or higher was evaluated as "favorable", and other cases were evaluated as "poor".

### <Composition for Forming Resin Film>

Respective components constituting the resin film forming layer are shown below. Binder polymer component (A): Copolymer of 85 parts by mass of methyl methacrylate and 15 parts by mass of 2-hydroxyethyl acrylate (weight average molecular weight: 400,000, glass transition temperature: 6°C)

### Curable component (B):

Bisphenol A type epoxy resin (B1) (epoxy equivalent: 180 g/eq to 200 g/eq)
Dicyclopentadiene type epoxy resin (B2) (EPICLON HP-7200HH manufactured by DIC Corporation)
Dicyandiamide (B3) (ADEKA HARDENER 3636AS manufactured by ADEKA Corporation)

### Inorganic filler (C):

Boron nitride particles (C1) (UHP-2 manufactured by Showa Denko K.K., shape: plate shape, average particle size: 11.8 µm, aspect ratio: 11.2, thermal conductivity in the long axis direction: 200 W/(m·K), density: 2.3 g/cm³)
Alumina filler (C2) (CB-A20S manufactured by Showa Denko K.K., shape: spherical shape, average particle size: 20 µm, density: 4.0 g/cm³)
Silica filler (C3) (melt quartz filler, average particle size: 3 µm)

### Silane coupling agent (D):

Oligomer type silane coupling agent (D1) (X-41-1056 manufactured by Shin-Etsu Chemicals Co., Ltd., alkoxy equivalent: 17.1 mmol/g, molecular weight: 500 to 1,500)
Monomer type silane coupling agent (D2) (γ-glycidoxypropylmethyldiethoxysilane, KBE-402 manufactured by Shin-Etsu Chemicals Co., Ltd., alkoxy equivalent: 10.8 mmol/g, molecular weight: 248.4)
Coloring agent (E): Black pigment (carbon black, #MA650 manufactured by Mitsubishi Chemical Corporation, average particle size: 28 nm)
Curing accelerator (F): 2-phenyl-4,5-hydroxymethylimidazole (CUREZOL 2PHZ-PW manufactured by Shikoku Chemicals Corporation)

### (Examples and Comparative Examples)

The above respective components were mixed in amounts shown in Table 1, whereby compositions for forming a resin film were obtained. After the peeling-treated surface of a supporting sheet (SP-PET381031 manufactured by Lintec Corporation, thickness of 38 µm) which was peeling-treated with silicone was dried (drying conditions: 110 °C in the oven, for one minute), by applying thereto and drying a methyl ethyl ketone solution (solid concentration of 61% by weight) of the obtained composition such that the thickness became 40 µm, a resin film forming layer was formed on the supporting sheet, whereby a sheet for forming a resin film for chips was obtained.

**[Table 1]**

| | Example | | | | | | | Comparative Example | | | | | | | | |
|---|---|---|---|---|---|---|---|---|---|---|---|---|---|---|---|---|
| | 1 | 2 | 3 | 4 | 5 | 6 | 7 | 1 | 2 | 3 | 4 | 5 | 6 | 7 | 8 | 9 |
| A | 100 | 100 | 100 | 100 | 100 | 100 | 100 | 100 | 100 | 100 | 100 | 100 | 100 | 100 | 100 | 100 |
| B1 | 50 | 50 | 50 | 50 | 50 | 50 | 50 | 50 | 50 | 50 | 50 | 50 | 50 | 50 | 50 | 50 |
| B2 | 50 | 50 | 50 | 50 | 50 | 50 | 50 | 50 | 50 | 50 | 50 | 50 | 50 | 50 | 50 | 50 |
| B3 | 2.4 | 2.4 | 2.4 | 2.4 | 2.4 | 2.4 | 2.4 | 2.4 | 2.4 | 2.4 | 2.4 | 2.4 | 2.4 | 2.4 | 2.4 | 2.4 |
| C1 | 108.4 | 108.4 | 108.4 | 108.4 | 108.4 | 108.4 | 216.8 | 108.4 | 108.4 | 108.4 | 108.4 | 108.4 | 108.4 | 325.2 | | 325.2 |
| C2 | 216.8 | 216.8 | 216.8 | 216.8 | 216.8 | 216.8 | 108.4 | 216.8 | 216.8 | 216.8 | 216.8 | 216.8 | 216.8 | | | |
| C3 | | | | | | | | | | | | | | | 325.2 | |
| D1 | 2 | 2.7 | 3.8 | 5.4 | 11 | 16.7 | 10 | | | | | | | | 2 | |
| D2 | | | | | | | | | 2 | 2.7 | 3.8 | 5.4 | 11 | 16.7 | | |
| E | 10 | 10 | 10 | 10 | 10 | 10 | 10 | 10 | 10 | 10 | 10 | 10 | 10 | 10 | 10 | 10 |
| F | 2.4 | 2.4 | 2.4 | 2.4 | 2.4 | 2.4 | 2.4 | 2.4 | 2.4 | 2.4 | 2.4 | 2.4 | 2.4 | 2.4 | 2.4 | 2.4 |

| | | | | | | | | | | | | | | | | |
|---|---|---|---|---|---|---|---|---|---|---|---|---|---|---|---|---|
| Unit: Parts by weight (value in terms of solid content) | | | | | | | | | | | | | | | | |

<Evaluation of Peeling Strength> and <Measurement of Thermal Conductivity> were performed on the obtained sheets for forming a resin film for chips. The results are shown in Table 2. Moreover, the peeling strength of the sheet for forming a resin film for chips of Comparative Example 9 could not be measured since the peeling strength thereof was below the measuring lower limit.

**[Table 2]**

| | Peeling strength | | Thermal conductivity [W/(m· K)] | | | |
|---|---|---|---|---|---|---|
| | [N/10mm] | Evaluation | Before curing (resin film forming layer) | Evaluation | After Curing (resin film) | Evaluation |
| Example 1 | 3.7 | Favorable | 3 | Favorable | 3 | Favorable |
| Example 2 | 4.4 | Favorable | 3 | Favorable | 3 | Favorable |
| Example 3 | 6.2 | Favorable | 3 | Favorable | 3 | Favorable |
| Example 4 | 7.1 | Favorable | 3 | Favorable | 3 | Favorable |
| Example 5 | 7.6 | Favorable | 3 | Favorable | 3 | Favorable |
| Example 6 | 7.3 | Favorable | 3 | Favorable | 3 | Favorable |
| Example 7 | 4 | Favorable | 3.5 | Favorable | 3.5 | Favorable |
| Comparative Example 1 | 2.1 | Poor | 3 | Favorable | 3 | Favorable |
| Comparative Example 2 | 2.6 | Poor | 3 | Favorable | 3 | Favorable |
| Comparative Example 3 | 3.2 | Poor | 3 | Favorable | 3 | Favorable |
| Comparative Example 4 | 3.2 | Poor | 3 | Favorable | 3 | Favorable |
| Comparative Example 5 | 3.4 | Poor | 3 | Favorable | 3 | Favorable |
| Comparative Example 6 | 3.4 | Poor | 3 | Favorable | 3 | Favorable |
| Comparative Example 7 | 3.2 | Poor | 3 | Favorable | 3 | Favorable |
| Comparative Example 8 | 9.1 | Favorable | 0.8 | Poor | 0.8 | Poor |
| Comparative Example 9 | - | - | 4 | Favorable | 4 | Favorable |

The resin film forming layers of the sheets for forming a resin film for chips of Examples exhibited excellent peeling strength and thermal conductivity. Therefore, by using the sheet for forming a resin film for chips according to the present invention, it is possible to obtain a highly reliable semiconductor device.

## Claims

1. A sheet for forming a resin film for chips, comprising:
a supporting sheet; and
a resin film forming layer which is formed on the supporting sheet,
wherein the resin film forming layer comprises a binder polymer component (A), a curable component (B), an inorganic filler (C), and an oligomer type silane coupling agent (D),
the inorganic filler (C) comprises anisotropic shape nitride particles (C1) having an average particle size of 20 µm or less and other particles (C2) which are other than the anisotropic shape nitride particles (C1) and have an average particle size of 20 µm or more, the other particles (C2) comprising at least one particle selected from the group consisting of silica particles and alumina particles, and
the molecular weight of the oligomer type silane coupling agent (D) is 300 or greater.

2. The sheet for forming a resin film for chips according to Claim 1, wherein the mass ratio of the oligomer type silane coupling agent (D) in the total mass of the resin film forming layer is 0.3% by mass to 2% by mass.

3. The sheet for forming a resin film for chips according to Claims 1 or 2, wherein the alkoxy equivalent of the oligomer type silane coupling agent (D) is 10 mmol/g to 40 mmol/g.

4. The sheet for forming a resin film for chips according to any one of Claims 1 to 3, wherein the mass ratio of the anisotropic shape nitride particles (C1) in the total mass of the resin film forming layer is 40% by mass or less.

5. The sheet for forming a resin film for chips according to any one of Claims 1 to 4, wherein the mass ratio of the inorganic filler (C) in the total mass of the resin film forming layer is 30% by mass to 60% by mass.

6. The sheet for forming a resin film for chips according to any one of Claims 1 to 5, wherein the anisotropic shape nitride particles (C1) are boron nitride particles.

7. The sheet for forming a resin film for chips according to any one of Claims 1 to 6, wherein the weight proportion (C1:C2) between the anisotropic shape nitride particles (C1) and the other particles (C2) in the inorganic filler (C) is 1:5 to 5:1.

8. The sheet for forming a resin film for chips according to any one of Claims 1 to 7, wherein the average particle size of the other particles (C2) is 0.01 times to 0.65 times of the thickness of the resin film forming layer.

9. The sheet for forming a resin film for chips according to any one of Claims 1 to 8, wherein the peeling strength of the resin film forming layer from a copper foil is 3.5 N/10 mm to 10 N/10 mm.

10. The sheet for forming a resin film for chips according to any one of Claims 1 to 9, wherein the thermal conductivity of the resin film forming layer is 2 W/(m·K) or higher.

11. A method for manufacturing a semiconductor device, wherein the sheet according to any one of claims 1 to 10 is used for forming a resin film for chips

## Patentansprüche

1. Folie zur Ausbildung eines Harzfilms für Chips, umfassend:
eine Trägerfolie; und
eine Harzfilm-Ausbildungsschicht, die auf der Trägerfolie ausgebildet ist,
wobei die Harzfilm-Ausbildungsschicht eine Bindemittel-Polymerkomponente (A), eine aushärtbare Komponente (B), ein anorganisches Füllmaterial (C) und einen oligomeren Silanhaftvermittler (D) umfasst,
das anorganische Füllmaterial (C) anisotrop geformte Nitrid-Teilchen (C1), die eine durchschnittliche Teilchengröße von 20 µm oder weniger haben, und andere Teilchen (C2) umfasst, die anders als die anisotrop geformten Nitrid-Teilchen (C1) sind und eine durchschnittliche Teilchengröße von 20 µm oder mehr haben, wobei die anderen Teilchen (C2) mindestens ein Teilchen umfassen, das aus der Gruppe ausgewählt ist, die aus Siliciumdioxid-Teilchen und Aluminiumoxid-Teilchen besteht, und
das Molekulargewicht des oligomeren Silanhaftvermittlers (D) 300 oder mehr ist.

2. Folie zur Ausbildung eines Harzfilms für Chips gemäß Anspruch 1, wobei der Massenanteil des oligomeren Silanhaftvermittlers (D) in der Gesamtmasse der Harzfilm-Ausbildungsschicht 0,3 Gewichts-% bis 2 Gewichts-% ist.

3. Folie zur Ausbildung eines Harzfilms für Chips gemäß Anspruch 1 oder 2, wobei das Alkoxy-Äquivalent des oligomeren Silanhaftvermittlers (D) 10 mmol/g bis 40 mmol/g ist.

4. Folie zur Ausbildung eines Harzfilms für Chips gemäß einem der Ansprüche 1 bis 3, wobei der Massenanteil der anisotrop geformten Nitrid-Teilchen (C1) in der Gesamtmasse des Harzfilm-Ausbildungsschicht 40 Gewichts-% oder weniger ist.

5. Folie zur Ausbildung eines Harzfilms für Chips gemäß einem der Ansprüche 1 bis 4, wobei der Massenanteil des anorganischen Füllmaterials (C) in der Gesamtmasse der Harzfilm-Ausbildungsschicht 30 Gewichts-% bis 60 Gewichts-% ist.

6. Folie zur Ausbildung eines Harzfilms für Chips gemäß einem der Ansprüche 1 bis 5, wobei die anisotrop geformten Nitrid-Teilchen (C1) Bornitrid-Teilchen sind.

7. Folie zur Ausbildung eines Harzfilms für Chips gemäß einem der Ansprüche 1 bis 6, wobei das Gewichtsverhältnis (C1:C2) der anisotrop geformten Nitrid-Teilchen (C1) zu den anderen Teilchen (C2) in dem anorganischen Füllmaterial (C) 1:5 bis 5:1 ist.

8. Folie zur Ausbildung eines Harzfilms für Chips gemäß einem der Ansprüche 1 bis 7, wobei die durchschnittliche Teilchengröße der anderen Teilchen (C2) 0,01 mal bis 0,65 mal die Dicke der Harzfilm-Ausbildungsschicht ist.

9. Folie zur Ausbildung eines Harzfilms für Chips gemäß einem der Ansprüche 1 bis 8, wobei die Schälfestigkeit der Harzfilm-Ausbildungsschicht von einer Kupferfolie 3,5 N/10 mm bis 10 N/10 mm ist.

10. Folie zur Ausbildung eines Harzfilms für Chips gemäß einem der Ansprüche 1 bis 9, wobei die Wärmeleitfähigkeit der Harzfilm-Ausbildungsschicht 2 W/(m·K) oder höher ist.

11. Verfahren zur Herstellung einer Halbleitervorrichtung, wobei die Folie gemäß einem der Ansprüche 1 bis 10 zum Ausbilden eines Harzfilms für Chips verwendet wird.

## Revendications

1. Feuille pour former un film de résine pour puces, comprenant:
une feuille de support; et
une couche formant un film de résine qui est formée sur la feuille de support,
où la couche formant un film de résine comprend un composant polymère lieur (A), un composant durcissable (B), une charge inorganique (C) et un agent de couplage silane de type oligomère (D),
la charge inorganique (C) comprend des particules de nitrure de forme anisotrope (C1) ayant une taille de particule moyenne de 20 µm ou moins et d'autres particules (C2) qui sont différentes des particules de nitrure de forme anisotrope (C1) et ont une taille de particule moyenne de 20 µm ou plus, les autres particules (C2) comprenant au moins une particule choisie dans le groupe consistant en les particules de silice et les particules d'alumine, et
le poids moléculaire de l'agent de couplage silane de type oligomère (D) est 300 ou plus.

2. Feuille pour former un film de résine pour puces selon la revendication 1, où la proportion massique de l'agent de couplage silane de type oligomère (D) dans la masse totale de la couche formant un film de résine est 0,3% en masse à 2% en masse.

3. Feuille pour former un film de résine pour puces selon la revendication 1 ou 2, où l'équivalent d'alcoxy de l'agent de couplage silane de type oligomère (D) est 10 mmol/g à 40 mmol/g.

4. Feuille pour former un film de résine pour puces selon l'une quelconque des revendications 1 à 3, où la proportion massique des particules de nitrure de forme anisotrope (C1) dans la masse totale de la couche formant un film de résine est 40% en masse ou moins.

5. Feuille pour former un film de résine pour puces selon l'une quelconque des revendications 1 à 4, où la proportion massique de la charge minérale (C) dans la masse totale de la couche formant un film de résine est 30% en masse à 60% en masse.

6. Feuille pour former un film de résine pour puces selon l'une quelconque des revendications 1 à 5, où les particules de nitrure de forme anisotrope (C1) sont des particules de nitrure de bore.

7. Feuille pour former un film de résine pour puces selon l'une quelconque des revendications 1 à 6, où la proportion pondérale (C1:C2) entre les particules de nitrure de forme anisotrope (C1) et les autres particules (C2) dans la charge inorganique (C) est 1:5 à 5:1.

8. Feuille pour former un film de résine pour puces selon l'une quelconque des revendications 1 à 7, où la taille de particule moyenne des autres particules (C2) est 0,01 fois à 0,65 fois l'épaisseur de la couche formant un film de résine.

9. Feuille pour former un film de résine pour puces selon l'une quelconque des revendications 1 à 8, où la résistance au pelage de la couche formant un film de résine d'une feuille de cuivre est 3,5 N/10 mm à 10 N/10 mm.

10. Feuille pour former un film de résine pour puces selon l'une quelconque des revendications 1 à 9, où la conductivité thermique de la couche formant un film de résine est 2 W/(m.K) ou plus.

11. Procédé pour fabriquer un dispositif à semi-conducteurs où la feuille selon l'une quelconque des revendications 1 à 10 est utilisée pour former un film de résine pour puces.
